# EUROPEAN PATENT SPECIFICATION

(11) **EP 2 649 224 B1**
(45) Date of publication and mention of the grant of the patent: **23.03.2016**
(21) Application number: 11794451.2
(22) Date of filing: 05.12.2011
(51) Int. Cl.: C25D 11/04, C25D 11/16

(54) **A METHOD TO OBTAIN A RADIATION SCATTERING SURFACE FINISH ON AN OBJECT**
VERFAHREN ZUR HERSTELLUNG EINER STRAHLUNGSSTREUUNGSENDOBERFLÄCHE AUF EINEM GEGENSTAND
PROCÉDÉ PERMETTANT D'OBTENIR UN FINI DE SURFACE DE DIFFUSION DES RAYONNEMENTS SUR UN OBJET

(30) Priority: 06.12.2010 DK 201001103; 30.03.2011 DK 201100232; 30.03.2011 DK 201100233
(43) Date of publication of application: 16.10.2013
(73) Proprietor: Bang & Olufsen A/S, 7600 Struer (DK)
(72) Inventor: KONGSTAD, Ib, DK-7600 Struer (DK)
(74) Representative: Inspicos P/S
(86) International application number: PCT/EP2011/071748
(87) International publication number: WO 2012/076467

(56) References cited:
- EP-A2- 1 538 240
- GB-A- 873 450
- GB-A- 2 146 042
- US-A- 3 400 057
- US-A- 3 865 560
- US-A1- 2008 265 218
- DATABASE WPI Week 197931 Thomson Scientific, London, GB; AN 1979-57366B XP002697566, & JP S54 18666 B (KANSAI PAINT CO LTD) 9 July 1979 (1979-07-09)

## Description

### FIELD OF THE INVENTION

The present invention relates to a method to obtain a radiation scattering surface finish on an object, to an object comprising a substrate and an anodic oxide layer comprising radiation scattering elements as well as a use of radiation scattering elements in an anodic oxide layer for providing a decorative surface finish to an object.

### BACKGROUND OF THE INVENTION

In the art it is well known to anodise aluminium surfaces to obtain increased corrosion and wear resistance as well as cosmetic effects and high durability.

The final result of the anodised surface depends strongly on the micro structure of the substrate, which components are included in the substrate and how components are distributed.

For the decorative aspects of the surface it is important that the final processing is well defined and fully controlled within specific boundaries.

From white paint it is known that the final visual result of the surface - white colour - depends strongly on the micro structure of the continuum phase and which components are included in the substrate and how components are mixed.

An example where a quality surface may be obtained is an aluminium object onto which pure Al is evaporated in a PVD process succeeded by polishing and anodising. This method may be applied on different types of substrates, such as metal and also on glass and plastics.

GB 873 450 A relates to a method of producing a decorative surface of aluminium incorporating areas of different light reflectivity, which comprises combining two pieces of aluminium of different compositions into a single unit having a substantially smooth, composite surface.

GB 2 146 042 A discloses a method for surface treatment of aluminium or aluminium alloys having an anodically oxidized film by dipping in a first solution containing at least one salt, and subsequently electrolyzing with a second solution containing one or more substances which react with the product from said salt in the micropores of the anodically oxidized film to be converted into a white or grayish white compound.

GB 2400113 A relates to a method of forming a base for a decorative layer comprising forming a material capable of forming an interference metal oxide onto a material capable of forming an anodic oxide.

US 2010/0021757 A1 relates to a surface coating with bright appearance on a motor vehicle wheel, wherein said wheel is made of light metal alloy castings or steel, and a method for producing a resistant bright coating on aluminium alloy or steel surfaces, which method comprises the steps of gas-phase deposition of aluminium or Al ally to form a first dense and bright coating, and electrochemical oxidation of the surface of the first layer and formation of a nanoporous to microporous second layer of aluminium oxide.

US 3 400 057 A relates to a method of imparting to the surface of an aluminium base alloy containing from about 5% to about 9% silicon by weight an anodized finish having a sparkling appearance by embedding silicon particles.

US 3 865 560 A relates to a process for manufacturing composite sheets including a face sheet of aluminium or an alloy of aluminium having on the surface local chemical heterogeneities capable of causing variation in tint in response to anodization.

US 5, 510,015 relates to a process for obtaining a range of colours of the visible spectrum using electrolysis on anodised aluminium, comprising a first phase to form an anodic film which comprises a barrier film, a second phase to modify the barrier film and a third phase to deposit metallic particles on the barrier film.

US 2004/0247904 relates to a method of surface-treating a solid substrate including the steps of depositing a layer of aluminium-titanium alloy onto the substrate and subsequently subjecting the substrate to anodic oxidation.

US 2005/0115839 A1 relates to a method of forming a second protective coating on a surface of an article having a first protective coating comprising an aluminium or aluminium alloy coating using aqueous electrolytes containing complex fluorides or oxyfluorides such as fluorozirconates and fluorotitanates.

US 2010/0252241 A1 relates to a ceramic coated heat exchanger component and method for making the ceramic coated heat exchanger component by creating porous metal oxide coatings on an aluminium surface of the heat exchanger component by plasma electrochemical deposition of a metal oxide on the aluminium surface.

EP 290 841 A relates to a method of surface anodisation of objects of aluminium wherein aluminium is deposited on the objects prior to anodisation through physical vapour deposition.

### OBJECT OF THE INVENTION

It is an object of embodiments of the invention to provide a method to obtain a radiation scattering surface finish on an object in order to further enhance decorative effects to maximize the quality of the visual appearance.

The invention includes designing special structures in the uppermost layer of aluminium based material.

Normally anodised Al surfaces displays grey or other colours red, blue and other, but not white or pastel colours.

Thus, an important aspect of the invention is that it discloses a method to obtain a pure white anodised surface.

Primary features obtained by the invention are:
a) a white surface finish on Al or Al alloy
b) special decorative features on Al or Al alloy
c) Optical interference (butterfly wing effect).

After anodising the structures show the desired (as designed) optical phenomena.

Another object of embodiments of the invention is to provide an object having a radiation scattering surface finish in order to further enhance decorative effects to maximize the quality of the visual appearance.

Another object is to provide a use of radiation scattering elements in an anodic oxide layer for providing a decorative surface finish to an object.

### SUMMARY OF THE INVENTION

It has been found by the present inventor(s) that the above objects may be obtained by a method to obtain a radiation scattering surface finish on an object by the inclusion of discrete radiation scattering elements.

So, in a first aspect the present invention relates to a method to obtain a radiation scattering surface finish on an object comprising the steps:
a) providing the object with a top layer comprising aluminium or an aluminium alloy, the top layer comprising added discrete inclusions of a second material being different from aluminium and the first alloy, and
b) subsequently anodising said top layer to form an anodic oxide layer and to generate from the inclusions discrete radiation scattering elements,
wherein the difference between a refractive index of the discrete radiation scattering elements and a refractive index of the anodic oxide layer is in the range of 0.1 - 3.0, preferably in the range 1.0-3.0, wherein the particle size of the radiation scattering elements is in the range 1 nm-10 µm, and wherein the added discrete inclusions are selected from the group consisting of particles of metals and of metal oxides.

The invention discloses a method to obtain decorative effects of an anodised surface to maximize the quality of the visual appearance, such as an anodised white surface.

A white surface finish can be obtained by intentionally contaminating, i.e. providing discrete inclusions in, the alumina layer (aluminium oxide Al₂O₃) or any oxide of an aluminium alloy so that the contaminants in the form of radiation scattering elements cause light scattering.

Thus, particles may cause white light scattering.

The contaminants/discrete inclusions are added to the metallic aluminium and subsequently "dragged" (also named activated) into the oxide layer by means of anodising, in which the aluminium is transformed into aluminium oxide.

The contaminants can either maintain their original structure or can be oxidized in the anodising process. The anodising as applied may be a standard 5-50 µm oxide process.

Thus, an aspect of the invention is a method and a process to obtain a white surface finish on Al objects or Al alloy objects by applying an anodising process, and where
the contaminants are added randomly in the topcoat,
the contaminants are activated into the oxide layer by anodising, wherein
the contaminants maintain their original structure, or
the contaminants are oxidized, dissolved or vaporised.

In a second aspect the present invention relates to an object comprising the following layers:
a substrate; and
an anodic oxide layer comprising radiation scattering elements, wherein the difference between a refractive index of the discrete radiation scattering elements and a refractive index of the anodic oxide layer is in the range of 0.1 - 3.0, preferably in the range 1.0-3.0, wherein the particle size of the radiation scattering elements is in the range 1 nm-10 µm, and wherein the added discrete inclusions are selected from the group consisting of particles of metals and of metal oxides.

Legends to the figure
Fig. 1 illustrates the basic structure of an object according to the invention,
Fig. 2 illustrates a method according to the invention employing a PVD process, and
Fig. 3 illustrates a method according to the invention employing a PVD process and further comprising a heat treatment step before anodising.

### DETAILED DISCLOSURE OF THE INVENTION

### Definitions

The term "radiation scattering surface finish" in the present context is used to describe a surface finish in which incoming radiation in the form of either infra-red radiation, radiation of light in the visible spectrum, or ultra-violet radiation is scattered from discrete radiation scattering elements included in a surface layer.

The term "aluminium alloy" is used to describe an alloy of aluminium and one or more further metals, such as titanium, zirconium, or a mixture thereof. Suitable alloys comprise about 80-99% of Al and about 1-20% of Ti or Zr or a mixture thereof.

The term "discrete inclusions" describes discrete, i.e. separate, included items, such as particles.

The term "particle size" of the radiation scattering elements describes the average diameter of the element in question, seen perpendicularly from the outside to the surface of the element.

The term "anodising" means an electrolytic passivation process by which a part to be treated forms the anode electrode of an electrical circuit. An anodised aluminium layer may thus be obtained by passing a direct current through an electrolytic solution with the aluminium object serving as the anode.

The term "PVD" or "Physical Vapour Deposition" describes a method to deposit thin films by the condensation of a vapourised form of the desired film material onto an object.

The term "laser cladding" describes a method of depositing material by which a powdered feedstock material is melted and consolidated by the use of a laser beam in order to form a layer on an object.

### Specific embodiments of the invention

In the method according to the invention the difference between a refractive index of the discrete radiation scattering elements and a refractive index of the anodic oxide layer is in the range of 0.1 - 3.0, preferably in the range 1.0-3.0. By having a difference in the refractive index between that of the radiation scattering elements and of the anodic oxide layer a radiation scattering effect may be obtained.

In the method according to the invention the particle size of the radiation scattering elements is in the range 1 nm-10 µm. Thus the particle size of the radiation scattering elements must be large enough to secure a radiation scattering effect and on the other hand small enough to enable incorporation in an anodic oxide layer and will depend also on the desired radiation scattering effect.

In an embodiment of the method according to the invention the added discrete inclusions maintain their original structure during anodising so that the added discrete inclusions are also the discrete radiation scattering elements. Thus the discrete inclusions provided in the top layer may be unaffected by the anodisation process, such as in the case of inclusions in the form of particles of metal oxides.

In an embodiment of the method according to the invention the added discrete inclusions are converted to an oxidized, dissolved or vaporised form in the anodic oxide layer during anodising. In this embodiment the added discrete inclusions are converted during the anodisation process to an oxidised, a dissolved or a vaporised form, such as in the case of discrete inclusions in the form of metals that are converted to discrete radiation scattering elements in the form of e.g. the corresponding metal oxides.

In an embodiment of the method according to the invention the top layer comprising aluminium or an aluminium alloy and added discrete inclusions is placed as one layer onto the surface of the object.

In an embodiment of the method according to the invention the top layer comprises two or more individual layers, each individual layer comprising aluminium or an aluminium alloy and added discrete inclusions of a second material being different from aluminium and the aluminium alloy, wherein each individual layer may be different from or the same as any other individual layer. Through the use of several layers of aluminium or aluminium alloy, which may be the same or different, and the use of added discrete inclusions, which may also be the same or different in each individual layer, the possibility is provided for a tailor-made surface finish of the object.

In an embodiment of the method according to the invention step a) comprises:
i) providing aluminium or an aluminium alloy in a molten state;
ii) adding discrete inclusions, and
iii) cooling to obtain a top layer.

Thus in an embodiment of the invention, aluminium or an aluminium alloy is melted and discrete inclusions are added thereto, whereupon the combination of aluminium or an aluminium alloy and discrete inclusions are provided as a top layer on an object and cooled down. Alternatively the combination of aluminium or an aluminium alloy and discrete inclusions are provided in a mould to form an object and cooled down.

The substances that create radiation scattering effect, such as visible light scattering effect, are added to the metallic Al in the melting process and subsequently developed into the oxide layer by means of anodizing, in which the aluminium or aluminium alloy is transformed into alumina or oxide of aluminium alloy, respectively.

Thus an embodiment of the invention is a method to obtain a white surface finish on Al objects or Al alloy objects by applying an anodizing process, and where the particles are added in the melting process of Al,

the particles are activated into the oxide layer by anodizing, wherein

the particles maintain their original structure, or

the particles are oxidized.

An example where a white high quality Al surface may be obtained is:
The pure Al or the Al alloy is loaded with discrete inclusions, such as particles, in the melting process and then polished and anodized.

In an embodiment of the invention discrete inclusions are thus mixed intimately with the Al or Al alloy in the melting process and distributed more or less evenly therein.

The anodized surface may obtain a white light scattering effect.

The Al or Al alloy may be used for casted Al, Al-profiles and Al rolled plates. In another embodiment of the invention the Al or Al alloy loaded with e.g. pigments may be positioned only in the outer surface by special methods. Thus bars for a rolling plate process having a thickness of about 200-800 mm, such as about 400 mm and having discrete inclusions placed in an outer layer of about 5-25 mm, such as about 10mm on both sides or only at one side may be subjected to casting. Correspondingly the same is possible on e.g. extrusion bolts that could be double casted to achieve an outer layer of about 5-25 mm, such as about 10 mm cylindrical layer that after extrusion still may form the outer surface.

In an embodiment of the method according to the invention step a) comprises:
i) providing aluminium or an aluminium alloy via a PVD process,
ii) providing discrete inclusions,
iii) repeating steps i) and ii) to obtain a top layer, and optionally thereafter
iv) providing a final aluminium or an aluminium alloy layer via a PVD process.

Thus in an embodiment of the invention aluminium or an aluminium alloy is provided via a PVD process in a continuous or discontinuous process, and steps i) and ii) are repeated until the desired thickness of the top layer is obtained. Optionally, a final aluminium or aluminium alloy layer without discrete inclusions may be provided in order to provide for a smooth surface ready for further processing such as casting, extrusion or rolling. The invention includes designing special structures in the PVD layer. The substances that create white light scattering are added together with evaporation of the PVD metallic Al and subsequently developed into the oxide layer by means of anodizing, in which the Al is transformed into alumina.

In an embodiment of the method according to the invention step a) comprises:
i) providing discrete inclusions in a carrier and deposit same on an object,
ii) providing aluminium or an aluminium alloy on said object,
iii) melting and consolidating aluminium or an aluminium alloy by the use of laser cladding.

In an embodiment of the invention discrete inclusions in a carrier, such as a vaporisable liquid, such as a polymer or a wax, is deposited on an object and aluminium or an aluminium alloy is provided in e.g. powdered form and melted and consolidated by the use of laser cladding to obtain a top layer comprising aluminium or an aluminium alloy, the top layer further comprising discrete inclusions.

In an embodiment of the method according to the invention step a) comprises:
i) providing discrete inclusions,
ii) providing aluminium or an aluminium alloy,
iii) mixing said discrete inclusions and said aluminium or an aluminium alloy,
iv) melting and consolidating aluminium or an aluminium alloy by the use of laser cladding.

In an embodiment of the invention the discrete inclusion and aluminium or an aluminium alloy are mixed before the step of melting and consolidating aluminium or an aluminium alloy by the use of laser cladding.

In an embodiment of the method according to the invention the added discrete inclusions are selected from the group consisting of particles of titanium, tin, zirconium, iron, titanium oxide, tin oxide, zirconium oxide, and iron oxide.

In an embodiment of the method according to the invention the added discrete inclusions are provided in a volume in the range 1-50% by volume of aluminium/aluminium alloy, more preferably in the range 5-50% by volume of aluminium/aluminium alloy. Thus depending on the intensity of the effect desired to be obtained the discrete inclusions are provided in a range of 1-50% by volume of aluminium/aluminium alloy.

In an embodiment of the method according to the invention the added discrete inclusions are selected from the group consisting of titanium, tin, zirconium, iron, titanium oxide, tin oxide, zirconium oxide, and iron oxide, said inclusions being present in an amount in the range 5-50% by weight of aluminium/ aluminium alloy.

Hereby a desired white surface finish of an object is obtained.

In an embodiment of the method according to the invention said method comprises a step d) of heat treatment prior to anodising. Through said heat treatment at a temperature in the range 400 - 700 °C, such as about 550 °C and subsequent slow cooling the added discrete inclusions may consolidate or nucleate to provide a stronger radiation scattering effect. Furthermore in the case of an aluminium alloy a heat treatment at a temperature in the above range and subsequent rapid cooling in a manner known per se may increase the hardness of said first aluminium alloy before any subsequent processing, such as mechanical polishing.

In an embodiment of the method according to the invention said method comprises a step c) of depositing at least one barrier layer onto said object before steps a) and b). In order to provide a stop layer for the subsequent anodisation step a barrier layer is suitably provided on the object as an innermost layer.

In an embodiment of the method according to the invention said barrier layer is a layer of an Al alloy, a Zr alloy, or a Ti alloy, preferably an alloy of aluminium and titanium and/or zirconium. Suitable alloys comprise about 80-99% of Al and about 1-20% of Ti or Zr or a mixture thereof. Thus an alloy of e.g. about 90% Al and about 10% Ti is effective as a stop layer for the subsequent anodisation.

In an embodiment of the method according to the invention said method comprises a step e) of depositing a protective layer on the anodic oxide layer after steps a) and b). A protective layer may suitably be provided as e.g. corrosion inhibiting layer for applications in harsh environments, such as high pH in e.g. automatic car washing applications or to protect handheld surfaces such as telephone handsets, remote controls etc.

In an embodiment of the method according to the invention said protective layer is a layer of an oxide of aluminium, titanium or zirconium or a mixed oxide of aluminium and titanium and/or zirconium.

In an embodiment of the object according to the invention, said object comprises:
a. A substrate;
b. A top Al or Al alloy layer comprising radiation scattering elements;
c. An anodic oxide layer comprising radiation scattering elements.

In an embodiment of the object according to the invention the substrate is made of a substance selected from the group consisting of ceramics, glass, polymers, and metal, and is preferably an Al or Al alloy substrate.

In an embodiment of the object according to the invention the difference between a refractive index of the discrete radiation scattering elements and a refractive index of the anodic oxide layer is in the range of 0.1 - 3.0, preferably in the range 1.0-3.0.

In an embodiment of the object according to the invention the particle size of the radiation scattering elements is in the range 1 nm-10 µm.

The particle size(s) of the radiation scattering elements is/are chosen depending on the desired radiation scattering effect. Thus if a UV shielding effect is desired, a particle size corresponding to the range of ultraviolet radiation, i.e. about 10 nm-400 nm is chosen. If scattering of visible light is desired, a particle size corresponding to the range of visible light, i.e. about 100 nm - 1 µm is chosen, and if scattering of infrared light or near infrared radiation is desired, a particle size in the range 0.4 - 2 µm is chosen.

In an embodiment of the object according to the invention the particle size of the radiation scattering elements is in the range of about 10 nm-400 nm.

In an embodiment of the object according to the invention the particle size of the radiation scattering elements is in the range of about 100 nm - 1 µm.

In an embodiment of the object according to the invention the particle size of the radiation scattering elements is in the range of about 0.4 - 2 µm.

It is clear to a person skilled in the art that a combination of radiation scattering effects is possible by selecting particle sizes from within more than one of the above ranges.

In an embodiment of the object according to the invention the top layer comprising aluminium or an aluminium alloy and added discrete inclusions is present as one layer on the surface of the object.

In an embodiment of the object according to the invention the top layer comprises two or more individual layers, each individual layer comprising aluminium or an aluminium alloy and discrete radiation scattering elements, wherein each individual layer may be different from or the same as any other individual layer.

In an embodiment of the object according to the invention the discrete radiation scattering elements are selected from the group consisting of particles of titanium, tin, zirconium, iron, titanium oxide, tin oxide, zirconium oxide, and iron oxide.

In an embodiment of the object according to the invention the volume of radiation scattering elements is in the range 1-50 % by volume of aluminium/aluminium alloy, more preferably in the range 5-50% by volume of aluminium/aluminium alloy. The particles that constitute the contaminants are characterized by having specific chosen light refractive index and light, such as white light scattering attributes.

Examples of light scattering contaminants are, but not limited to:
- Titanium dioxide, TiO₂
- Tin dioxide, SnO₂,
- Iron/steel oxide, Fe₂O₃ or FeO.

Examples of shape of particles:
Spheres,
Crystals,
Crushed minerals,
Prolates or oblates,
Flakes, or
Longish shape, fibres or needles.

In an embodiment of the object according to the invention the thickness of each of the top layer and the anodic oxide layer is in the range 5 µm-2 mm, preferably in the range 10 µm-1 mm, more preferably in the range 20 µm - 500 µm.

In an embodiment of the object according to the invention said object comprises a barrier layer between the substrate and the top layer comprising radiation scattering elements.

In an embodiment of the object according to the invention said barrier layer is a layer of an Al alloy, a Zr alloy, or a Ti alloy, preferably an alloy of aluminium and titanium and/or zirconium.

In an embodiment of the object according to the invention said object comprises a protective layer on top of the anodic oxide layer.

In an embodiment of the object according to the invention said protective layer is a layer of an oxide of aluminium, titanium or zirconium or a mixed oxide of aluminium and titanium and/or zirconium.

In an embodiment of the use of added radiation scattering elements in an anodic oxide layer said use is for providing a white surface finish to an object comprising a substrate and an anodic oxide layer.

In an embodiment of the use of added radiation scattering elements in an anodic oxide layer said use is for providing a pastel colour surface finish to an object comprising a substrate and an anodic oxide layer.

Further decorative effects can be obtained by implementing a multilayer structure of contaminants. Special graphical features with layered coatings will e.g. show interference at thin layers and show other effects by thicker layer.

Certain thin film processes (e.g. PVD and laser cladding) allow for the build-up of a multilayer aluminium structure, in which two or more alloys are sandwiched on top of each other.

The two (or more) alloys are selected so that there is a significant mismatch in their dying ability.

A mechanical denting process followed by grinding, polishing and anodising will reveal a structure which resembles the growth rings in wood.

The thickness of the individual layers of alloys can be adjusted to obtain different design expressions.

Thus, in yet another aspect of the invention the contaminants are added as two or more layers of structures placed onto the surface of the object. The thickness of each of the individual layers may typically be in the range 20µm -> 1mm.

Further and more advanced optical interference (butterfly wing effect) can be obtained.

Aluminium can be treated in a manner so that the surface obtains a structural colour variation (similar to butterfly wings, fish, peacocks and pearl seashells).

This quality of changing colours is known as iridescence and occurs when light passes through a transparent multilayered surface and is reflected more than once.

The multiple reflections compound one another and intensify colours.

The multilayered structure of aluminium can be made in numerous ways with PVD as an example.

For a skilled person, the disclosed method and technology may be applied in a numerous of variants according to actual product requirements.

The invention may be used in all types of equipment and apparatus, where there is a demand for a surface with a very nice looking expression/display and being highly resistive against corrosion.

Examples of equipment are, but not limited to: consumer electronics, phones, ear set, hearing aids, kitchen ware, jewelry, watches, furniture, window frames, building panels, control panels in cars, boats and airplanes and alike.

For illustration and for understanding the invention some examples are given below.

### EXAMPLE 1

Type 1 Al alloy is made from Al added some contaminants.

Type 2 Al alloy is made from Al added some other contaminants.

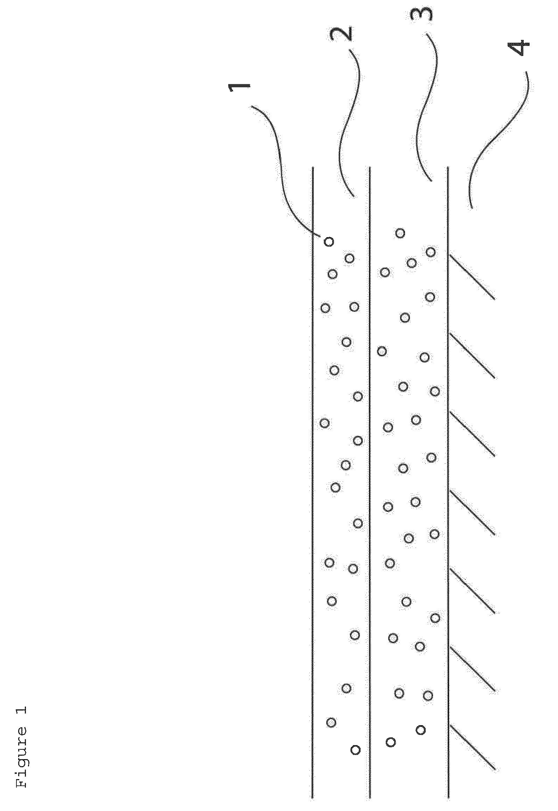

Figure 1 displays the layers of: the light scattering particles (1), the alumina layer (2), the top Al coat (3), and the base Al or Al alloy (4). After anodising the surface of the object appears white.

Many different decorative effects may be obtained applying the same method and process as disclosed in the invention. Two more examples are listed below. They do not limit the scope of the invention, but highlights some few additional features of the invention.

### EXAMPLE 2

Example 2 is an embodiment having the layers of: type 1 Al alloy, type 2 Al alloy, alumina made from type 1 Al alloy, and alumina made from type 2 Al alloy. After anodising the surface of the object appears to be as growth rings in wood.

### EXAMPLE 3

Example 3 is an embodiment having the layers of: type 1 Al alloy, type 2 Al alloy, semitransparent alumina made from type 1 Al alloy, semitransparent alumina made from type 2 Al alloy. After anodising the surface of the object appears to be as butterfly wings.

In this configuration the multilayers are composed with every second layer being the same material.

In other configurations the different layers may be varied material from layer to layer.

### EXAMPLE 4

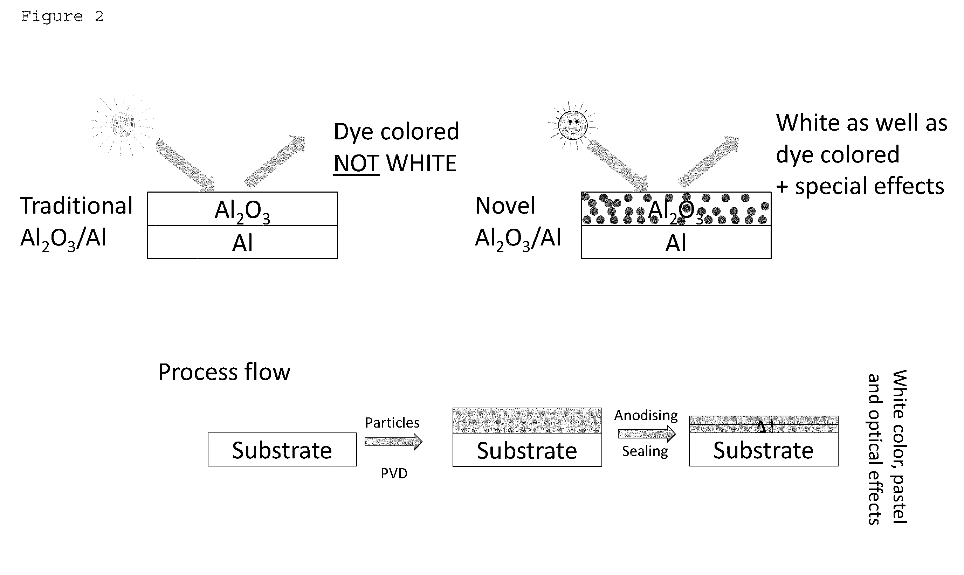

Figure 2 illustrates the method according to the invention wherein a PVD process is used. Thus discrete inclusions in the form of particles together with aluminium or an aluminium alloy are provided and form via a PVD process a top layer on a substrate, whereafter said top layer is anodised to form an anodic oxide layer comprising discrete radiation scattering elements.

### EXAMPLE 5

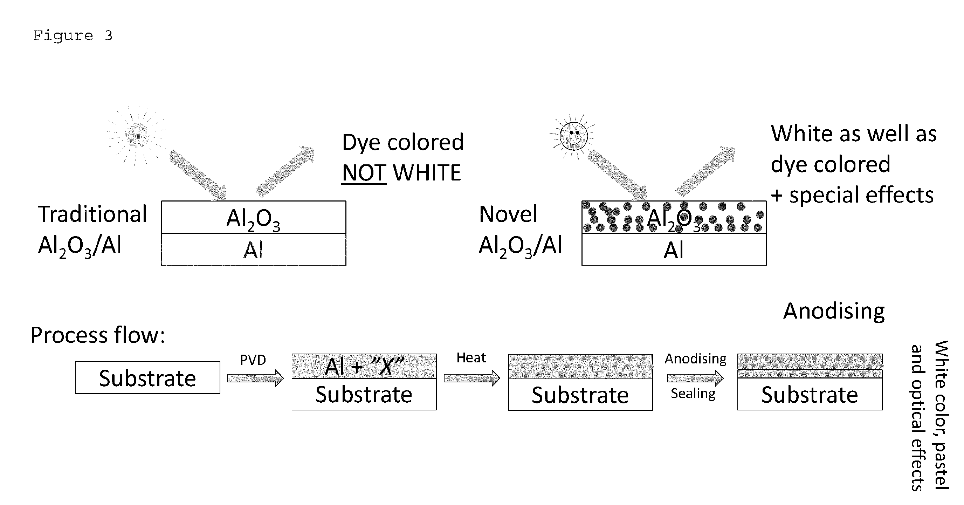

Figure 3 illustrates the method according to the invention wherein a PVD process is used and wherein a heat treatment step is performed before anodisation. Thus discrete inclusions in the form of particles together with aluminium or an aluminium alloy are provided and form via a PVD process a top layer on a substrate, whereafter said top layer is subjected to a heat treatment step at a temperature in the range 550 °C. before anodisation to form an anodic oxide layer comprising discrete radiation scattering elements.

### LIST OF REFERENCES

GB 873 450 A
GB 2 146 042 A
GB 2400113 A
US 2010/0021757 A1
US 5, 510,015
US 2004/0247904
US 2005/0115839 A1
US 2010/0252241 A1
US 3 400 057 A
US 3 865 560 A
EP 290 841 A

## Claims

1. A method to obtain a radiation scattering surface finish on an object comprising the steps:
a) providing the object with a top layer comprising aluminium or an aluminium alloy, the top layer comprising added discrete inclusions of a second material being different from aluminium and the first alloy, and
b) subsequently anodising said top layer to form an anodic oxide layer and to generate from the inclusions discrete radiation scattering elements,
wherein the difference between a refractive index of the discrete radiation scattering elements and a refractive index of the anodic oxide layer is in the range of 0.1 - 3.0, preferably in the range 1.0-3.0, wherein the particle size of the radiation scattering elements is in the range 1 nm-10 µm, and wherein the added discrete inclusions are selected from the group consisting of particles of metals and of metal oxides.

2. The method according to claim 1, wherein the added discrete inclusions maintain their original structure during anodising.

3. The method according to claim 1, wherein the added discrete inclusions are converted to an oxidized, dissolved or vaporised form in the anodic oxide layer during anodising.

4. The method according to any one of the preceding claims, wherein the top layer comprising aluminium or an aluminium alloy and added discrete inclusions is placed as one layer onto the surface of the object.

5. The method according to any one of claims 1-3, wherein the top layer comprises two or more individual layers, each individual layer comprising aluminium or an aluminium alloy and added discrete inclusions of a second material being different from aluminium and the aluminium alloy, wherein each individual layer may be different from or the same as any other individual layer.

6. The method according to any one of the preceding claims, wherein step a) comprises:
i) providing aluminium or an aluminium alloy in a molten state;
ii) adding discrete inclusions, and
iii) cooling to obtain a top layer.

7. The method according to any one of claims 1-5, wherein step a) comprises:
i) providing aluminium or an aluminium alloy via a PVD process,
ii) providing discrete inclusions,
iii) repeating steps i) and ii) to obtain a top layer, and optionally thereafter
iv) providing a final aluminium or an aluminium alloy layer via a PVD process.

8. The method according to any one of claims 1-5, wherein step a) comprises:
i) providing discrete inclusions in a carrier and deposit same on an object,
ii) providing aluminium or an aluminium alloy on said object,
iii) melting and consolidating aluminium or an aluminium alloy by the use of laser cladding.

9. The method according to any one of claims 1-5, wherein step a) comprises:
i) providing discrete inclusions,
ii) providing aluminium or an aluminium alloy,
iii) mixing the discrete inclusions and the aluminium or the first aluminium alloy,
iv) melting and consolidating aluminium or an aluminium alloy by the use of laser cladding.

10. The method according to any one of the preceding claims, wherein the added discrete inclusions are selected from the group consisting of particles of titanium, tin, zirconium, iron, titanium oxide, tin oxide, zirconium oxide, and iron oxide, preferably wherein the added discrete inclusions are provided in a volume in the range 1-50% by volume of aluminium/aluminium alloy, more preferably in the range 5-50% by volume of aluminium/aluminium alloy.

11. The method according to any one of the preceding claims, wherein the added discrete inclusions are selected from the group consisting of titanium, tin, zirconium, iron, titanium oxide, tin oxide, zirconium oxide, and iron oxide, said inclusions being present in an amount in the range 5-50% by weight of aluminium/ aluminium alloy.

12. The method according to any one of the preceding claims, comprising a step d) of heat treatment prior to anodising.

13. The method according to any one of the preceding claims, comprising a step c) of depositing at least one barrier layer onto said substrate before steps a) and b), preferably wherein said barrier layer is a layer of an Al alloy, a Zr alloy, or a Ti alloy, preferably an alloy of aluminium and titanium and/or zirconium.

14. The method according to any one of the preceding claims, comprising a step e) of depositing a protective layer on the anodic oxide layer after steps a) and b), preferably wherein said protective layer is a layer of an oxide of aluminium, titanium or zirconium or a mixed oxide of aluminium and titanium and/or zirconium.

15. An object comprising the following layers:
a) a substrate;
b) an anodic oxide layer comprising radiation scattering elements, wherein the difference between a refractive index of the discrete radiation scattering elements and a refractive index of the anodic oxide layer is in the range of 0.1 - 3.0, preferably in the range 1.0-3.0, wherein the particle size of the radiation scattering elements is in the range 1 nm-10 µm, and wherein the added discrete inclusions are selected from the group consisting of particles of metals and of metal oxides.

16. The object according to claim 15, comprising:
a) A substrate;
b) A top Al or Al alloy layer comprising radiation scattering elements;
c) An anodic oxide layer comprising radiation scattering elements.

17. The object according to claim 15 or 16, wherein the substrate is made of a substance selected from the group consisting of ceramics, glass, polymers, and metal, and is preferably an Al or Al alloy substrate.

## Patentansprüche

1. Verfahren zum Erhalten einer strahlungsstreuenden Oberflächenbeschaffenheit auf einem Objekt, das die folgenden Schritte umfasst:
a) Vorsehen des Objektes mit einer oberen Schicht, die Aluminium oder eine Aluminiumlegierung umfasst, wobei die obere Schicht hinzugefügte diskrete Einschlüsse eines zweiten Materials umfasst, die sich von Aluminium und der ersten Legierung unterscheiden, und
b) anschließend Eloxieren der oberen Schicht, um eine Eloxalschicht zu bilden und aus den Einschlüssen diskrete Strahlungsstreuungselemente zu erzeugen,
wobei die Differenz zwischen einem Brechungsindex der diskreten Strahlungsstreuelemente und einem Brechungsindex der Eloxalschicht im Bereich von 0,1 - 3,0 liegt, vorzugsweise im Bereich 1,0-3,0, wobei die Teilchengröße der Strahlungsstreuelemente im Bereich von 1 nm-10 µm liegt und wobei die zugesetzten diskreten Einschlüsse aus der Gruppe bestehend aus Teilchen von Metallen und Metalloxiden ausgewählt werden.

2. Verfahren nach Anspruch 1, wobei die zugesetzten diskreten Einschlüsse beim Eloxieren ihre ursprüngliche Struktur beibehalten.

3. Verfahren nach Anspruch 1, wobei die zugesetzten diskreten Einschlüsse in eine oxidierte, aufgelöste oder verdampfte Form im anodischen Oxid während des Eloxierens umgewandelt werden.

4. Verfahren nach einem der vorherigen Ansprüche, wobei die obere Schicht, die Aluminium oder eine Aluminiumlegierung und zugesetzte diskrete Einschlüsse umfasst, als eine Schicht auf die Oberfläche des Objektes gebracht ist.

5. Verfahren nach einem der Ansprüche 1-3, wobei die obere Schicht zwei oder mehr einzelne Schichten umfasst, wobei jede einzelne Schicht Aluminium oder eine Aluminiumlegierung und zugesetzte diskrete Einschlüsse eines zweiten Materials umfasst, das sich von Aluminium und der Aluminiumlegierung unterscheidet, wobei jede einzelne Schicht sich von einer anderen einzelnen Schicht unterscheiden oder dieselbe wie die andere einzelne Schicht sein kann.

6. Verfahren nach einem der vorherigen Ansprüche, wobei Schritt a) umfasst:
I) Bereitstellen von Aluminium oder einer Aluminiumlegierung in geschmolzenem Zustand;
II) Zusetzen von diskreten Einschlüssen, und
III) Kühlen, um eine obere Schicht zu erhalten.

7. Verfahren nach einem der Ansprüche 1-5, wobei Schritt a) umfasst:
I) Bereitstellen von Aluminium oder einer Aluminiumlegierung über einen PVD-Prozess,
II) Bereitstellen von diskreten Einschlüssen,
III) Wiederholen der Schritte I) und II), um eine obere Schicht zu erhalten, und optional danach
IV) Bereitstellen von letztem Aluminium oder einer Aluminiumlegierung über einen PVD-Prozess.

8. Verfahren nach einem der Ansprüche 1-5, wobei Schritt a) umfasst:
I) Bereitstellen von diskreten Einschlüssen in einem Träger und Abscheiden desselben auf einem Objekt,
II) Auftragen von Aluminium oder einer Aluminiumlegierung auf das Objekt,
III) Schmelzen und Erstarrenlassen von Aluminium oder einer Aluminiumlegierung durch Einsatz einer Laserplattierung.

9. Verfahren nach einem der Ansprüche 1-5, wobei Schritt a) umfasst:
I) Bereitstellen von diskreten Einschlüssen,
II) Bereitstellen von Aluminium oder einer Aluminiumlegierung,
III) Mischen der diskreten Einschlüsse und des Aluminiums oder der ersten Aluminiumlegierung,
IV) Schmelzen und Erstarrenlassen von Aluminium oder einer Aluminiumlegierung durch Einsatz einer Laserplattierung.

10. Verfahren nach einem der vorherigen Ansprüche, wobei die zugesetzten diskreten Einschlüsse aus der Gruppe bestehend aus Teilchen von Titan, Zinn, Zirkonium, Eisen, Titanoxid, Zinnoxid, Zirkoniumoxid und Eisenoxid ausgewählt werden, wobei vorzugsweise die zugesetzten Einschlüsse mit einem Volumen im Bereich von 1-50 Volumen-% des Aluminiums/der Aluminiumlegierung vorgesehen werden, besser im Bereich 5-50 Volumen-% von Aluminium/der Aluminiumlegierung.

11. Verfahren nach einem der vorherigen Ansprüche, wobei die zugesetzten diskreten Einschlüsse aus der Gruppe bestehend aus Titan, Zinn, Zirkonium, Eisen, Titanoxid, Zinnoxid, Zirkoniumoxid und Eisenoxid ausgewählt werden, wobei die Einschlüsse in einer Menge im Bereich von 5-50 Gewichts-% des Aluminiums/der Aluminiumlegierung vorhanden sind.

12. Verfahren nach einem der vorherigen Ansprüche, das einen Schritt d) der Wärmebehandlung vor dem Eloxieren umfasst.

13. Verfahren nach einem der vorherigen Ansprüche, das einen Schritt c) zum Abscheiden von mindestens einer Sperrschicht auf dem Substrat vor Schritt a) und b) umfasst, wobei die Sperrschicht vorzugsweise eine Schicht einer Al-Legierung, einer Zr-Legierung oder einer Ti-Legierung ist, vorzugsweise eine Legierung von Aluminium und Titan und/oder Zirkonium.

14. Verfahren nach einem der vorherigen Ansprüche, das einen Schritt e) zum Abscheiden einer Schutzschicht auf der Eloxalschicht nach Schritt a) und b) umfasst, wobei die Schutzschicht vorzugsweise eine Schicht aus einem Oxid von Aluminium, Titan oder Zirkonium oder einem Mischoxid von Aluminium und Titan und/oder Zirkonium ist.

15. Objekt, das die folgenden Schichten umfasst:
a) ein Substrat;
b) eine Eloxalschicht, die Strahlungsstreuelemente umfasst, wobei die Differenz zwischen einem Brechungsindex der diskreten Strahlungsstreuelemente und einem Brechungsindex der Eloxalschicht im Bereich von 0,1 - 3,0 liegt, vorzugsweise im Bereich 1,0-3,0, wobei die Teilchengröße der Strahlungsstreuelemente im Bereich von 1 nm-10 µm liegt und wobei die zugesetzten diskreten Einschlüsse aus der Gruppe bestehend aus Teilchen von Metallen und von Metalloxiden ausgewählt werden.

16. Objekt nach Anspruch 15, umfassend:
a) ein Substrat;
b) eine obere Al- oder Al-Legierungsschicht, die Strahlungsstreuelemente umfasst;
c) eine Eloxalschicht, die Strahlungsstreuelemente umfasst.

17. Objekt nach Anspruch 15 oder 16, wobei das Substrat aus einer Substanz hergestellt ist, die aus der Gruppe bestehend aus Keramik, Glas, Polymeren und Metall ausgewählt wird und vorzugsweise ein Al- oder Al-Legierungssubstrat ist.

## Revendications

1. Procédé permettant d'obtenir un fini de surface de diffusion des rayonnements sur un objet comprenant les étapes consistant à :
a) fournir l'objet avec une couche supérieure comprenant de l'aluminium ou un alliage d'aluminium, la couche supérieure comprenant des inclusions discrètes ajoutées d'un second matériau étant différent de l'aluminium et du premier alliage, et
b) ensuite anodiser ladite couche supérieure pour former une couche d'un oxyde anodique et pour générer à partir des inclusions discrètes les éléments de diffusion des rayonnements,
dans lequel la différence entre un indice de réfraction des éléments de diffusion des rayonnements discrets et un indice de réfraction de la couche d'un oxyde anodique est comprise dans la gamme allant de 0,1 à 3,0, de préférence dans la gamme allant de 1,0 à 3,0, dans lequel la taille de particule des éléments de diffusion des rayonnements est comprise dans la gamme allant de 1 nm à 10 µm, et dans lequel les inclusions discrètes ajoutées sont choisies parmi le groupe constitué de particules de métaux et des oxydes de métal.

2. Procédé selon la revendication 1, dans lequel les inclusions discrètes ajoutées maintiennent leur structure originale pendant l'anodisation.

3. Procédé selon la revendication 1, dans lequel les inclusions discrètes ajoutées sont converties en une forme oxydée, dissoute ou vaporisée dans la couche d'un oxyde anodique pendant l'anodisation.

4. Procédé selon l'une quelconque des revendications précédentes, dans lequel la couche supérieure comprenant de l'aluminium ou un alliage d'aluminium et des inclusions discrètes ajoutées est placée en tant que couche sur la surface de l'objet.

5. Procédé selon l'une quelconque des revendications 1 à 3, dans lequel la couche supérieure comprend deux ou plusieurs couches individuelles, chaque couche individuelle comprenant de l'aluminium ou un alliage d'aluminium et des inclusions discrètes ajoutées d'un second matériau étant différent de l'aluminium et de l'alliage d'aluminium, dans lequel chaque couche individuelle peut être différente de ou la même que toute autre couche individuelle.

6. Procédé selon l'une quelconque des revendications précédentes, dans lequel l'étape a) comprend les étapes consistant à :
i) fournir de l'aluminium ou un alliage d'aluminium dans un état fondu ;
ii) ajouter des inclusions discrètes, et
iii) refroidir pour obtenir une couche supérieure.

7. Procédé selon l'une quelconque des revendications 1 à 5, dans lequel l'étape a) comprend les étapes consistant à :
i) fournir de l'aluminium ou un alliage d'aluminium via un procédé PVD,
ii) fournir des inclusions discrètes,
iii) répéter les étapes i) et ii) pour obtenir une couche supérieure, et éventuellement par la suite
iv) fournir une couche finale d'aluminium ou d'un alliage d'aluminium via un procédé PVD.

8. Procédé selon l'une quelconque des revendications 1 à 5, dans lequel l'étape a) comprend les étapes consistant à :
i) fournir des inclusions discrètes dans un transporteur et déposer le même sur un objet,
ii) fournir de l'aluminium ou un alliage d'aluminium sur ledit objet,
iii) fondre et consolider l'aluminium ou un alliage d'aluminium par l'utilisation du découpage laser.

9. Procédé selon l'une quelconque des revendications 1 à 5, dans lequel l'étape a) comprend les étapes consistant à :
i) fournir des inclusions discrètes,
ii) fournir de l'aluminium ou un alliage d'aluminium,
iii) mélanger les inclusions discrètes et l'aluminium ou le premier alliage d'aluminium,
iv) faire fondre et consolider l'aluminium ou un alliage d'aluminium par l'utilisation du découpage laser.

10. Procédé selon l'une quelconque des revendications précédentes, dans lequel les inclusions discrètes ajoutées sont choisies parmi le groupe constitué des particules de titane, d'étain, de zirconium, de fer, d'oxyde de titane, d'oxyde d'étain, d'oxyde de zirconium, et d'oxyde de fer, de préférence dans lequel les inclusions discrètes ajoutées sont fournies dans un volume compris dans la gamme allant de 1 à 50% en volume d'aluminium/alliage d'aluminium, plus préférablement dans la gamme allant de 5 à 50% en volume d'aluminium/alliage d'aluminium.

11. Procédé selon l'une quelconque des revendications précédentes, dans lequel les inclusions discrètes ajoutées sont choisies parmi le groupe constitué du titane, de l'étain, du zirconium, du fer, de l'oxyde de titane, de l'oxyde d'étain, de l'oxyde de zirconium, et de l'oxyde de fer, lesdites inclusions étant présentes dans une quantité comprise dans la gamme allant de 5 à 50% en poids d'aluminium/alliage d'aluminium.

12. Procédé selon l'une quelconque des revendications précédentes, comprenant une étape d) de traitement thermique avant l'anodisation.

13. Procédé selon l'une quelconque des revendications précédentes, comprenant une étape c) de dépôt d'au moins une couche barrière sur ledit substrat avant les étapes a) et b), de préférence dans lequel ladite couche barrière est une couche d'un alliage d'Al, d'un alliage de Zr, ou d'un alliage de Ti, de préférence un alliage d'aluminium et de titane et/ou de zirconium.

14. Procédé selon l'une quelconque des revendications précédentes, comprenant une étape e) de dépôt d'une couche de protection sur la couche d'un oxyde anodique après les étapes a) et b), de préférence dans lequel ladite couche de protection est une couche d'un oxyde d'aluminium, de titane ou de zirconium ou un oxyde d'aluminium et de titane et/ou de zirconium mélangé.

15. Objet comprenant les couches suivantes :
a) un substrat ;
b) une couche d'un oxyde anodique comprenant les éléments de diffusion des rayonnements, dans lequel la différence entre un indice de réfraction des éléments de diffusion des rayonnements discrets et un indice de réfraction de la couche d'un oxyde anodique est comprise dans la gamme allant de 0,1 à 3,0, de préférence dans la gamme allant de 1,0 à 3,0, dans lequel la taille de particule des éléments de diffusion des rayonnements est comprise dans la gamme allant de 1 nm à 10 µm, et dans lequel les inclusions discrètes ajoutées sont choisies parmi le groupe constitué de particules de métaux et des oxydes de métal.

16. Objet selon la revendication 15, comprenant :
a) Un substrat ;
b) Une couche supérieure d'Al ou d'alliage d'Al comprenant les éléments de diffusion des rayonnements ;
c) Une couche d'un oxyde anodique comprenant les éléments de diffusion des rayonnements.

17. Objet selon les revendications 15 ou 16, dans lequel le substrat est fait d'une substance choisie parmi le groupe constitué de céramiques, de verre, de polymères, et de métal, et est de préférence un substrat d'Al ou d'alliage d'Al.
